# EUROPEAN PATENT APPLICATION

(11) **EP 3 605 725 A1**
(43) Date of publication of application: **05.02.2020**
(21) Application number: 18777485.6
(22) Date of filing: 19.02.2018
(51) Int. Cl.: H01P 5/02, H02M 1/08, H03K 17/691

(54) **ELECTROMAGNETIC RESONANCE COUPLER AND GATE DRIVE CIRCUIT USING SAME, AND SIGNAL TRANSMISSION DEVICE**

(30) Priority: 29.03.2017 JP 2017065852
(71) Applicant: Panasonic Corporation, Kadoma-shi, Osaka 571-8501 (JP)
(72) Inventor: KAWAI, Yasufumi, Osaka-shi, Osaka 540-6207 (JP); CHOE, Songbaek, Osaka-shi, Osaka 540-6207 (JP); ENOMOTO, Shingo, Osaka-shi, Osaka 540-6207 (JP); NEGORO, Noboru, Osaka-shi, Osaka 540-6207 (JP); NAGAI, Shuichi, Osaka-shi, Osaka 540-6207 (JP)
(74) Representative: Vigand, Philippe
(86) International application number: PCT/JP2018/005611
(87) International publication number: WO 2018/179985

(57) **Abstract**

An electromagnetic resonance coupler (100) includes a first transmission line (300) on a top surface of a dielectric layer (112), and a second transmission line (400) on a top surface of a dielectric layer (113). The first transmission line (300) includes resonance lines (301, 302) and input-output lines (303, 304). The second transmission line (400) includes resonance lines (401, 402) and input-output lines (403, 404). Cover grounds (501, 502) are provided separated from each other on the top surface of the dielectric layer (113) or the top surface of the dielectric layer (112). The resonance line (301) and the cover ground (501) are connected via a connector (503), and the resonance line (402) and the cover ground (502) are connected via a connector (504).

## Description

### TECHNICAL FIELD

The technology according to the present disclosure relates to an electromagnetic resonance coupler including a plurality of input-output terminals, a gate drive circuit using the electromagnetic resonance coupler, and a signal transmission device.

### BACKGROUND ART

Various electrical devices have been requested to meet the demand for signal transmission while electrical insulation is maintained between circuits. A drive-by-microwave technology using an electromagnetic resonance coupler has been developed as a method for transmitting an electrical signal and power simultaneously while maintaining electrical insulation (see Patent Literature (PTL) 1, for example). This technology is applied to, for example, an insulated gate drive circuit in which an input side is insulated from an output side (see PTL 2, for example).

Another technology has been developed for transmitting and receiving a plurality of signals separately using a single electromagnetic resonance coupler. This electromagnetic resonance coupler includes a transmitting resonance line having a plurality of input terminals and a receiving resonance line having a plurality of output terminals, and a middle part between the resonance lines is connected to the ground (see PTL 3 and 4, for example).

### Citation List

### Patent Literature

PTL 1: Japanese Unexamined Patent Application Publication No. 2008-067012
PTL 2: WO 2015/029363
PTL 3: WO 2013/065238
PTL 4: Japanese Unexamined Patent Application Publication No. 2015-213304

### SUMMARY OF THE INVENTION

### TECHNICAL PROBLEM

Unfortunately, for the conventional electromagnetic resonance coupler in PTL 3 and 4 having the input terminals and the output terminals inadequately separated, a high-power high-frequency signal from the transmitting side can possibly leak to an unintended terminal.

In response to the above issue, it is an object of the technology according to the present disclosure to provide a compact electromagnetic resonance coupler that includes an input terminal and an output terminal adequately separated from each other, a gate drive device including the electromagnetic resonance coupler, and a signal transmission device.

### SOLUTION TO PROBLEM

An electromagnetic resonance coupler according to an aspect of the present disclosure is an electromagnetic resonance coupler that transmits a plurality of signals independently between a plurality of transmission lines, and includes at least: a first transmission line; a second transmission line; a first dielectric layer having a top surface on which the first transmission line is disposed; and a second dielectric layer disposed above and apart from the first dielectric layer, and having a back surface on which the second transmission line is disposed, wherein the first transmission line includes: a first resonance line shaped in a loop and having a first opening; a second resonance line shaped in a loop and having a second opening; a first input-output line extending from the first resonance line; and a second input-output line extending from the second resonance line, the first resonance line and the second resonance line are disposed apart from each other on the top surface of the first dielectric layer, the second transmission line includes: a third resonance line shaped in a loop and having a third opening; a fourth resonance line shaped in a loop and having a fourth opening; a third input-output line extending from the third resonance line; and a fourth input-output line extending from the fourth resonance line, the third resonance line and the fourth resonance line are disposed apart from each other on the back surface of the second dielectric layer, the first resonance line and the third resonance line are disposed to overlap each other in plan view, and the second resonance line and the fourth resonance line are disposed to overlap each other in plan view, one of the first dielectric layer and the second dielectric layer includes a third ground part connected to the third resonance line via a third connector, one of the first dielectric layer and the second dielectric layer includes a fourth ground part connected to the fourth resonance line via a fourth connector, and the third ground part and the fourth ground part are separated from each other.

### ADVANTAGEOUS EFFECT OF INVENTION

The technology according to the present disclosure can reduce signal leakage inside an electromagnetic resonance coupler and also enables signals at different power levels to be transmitted independently from the single electromagnetic resonance coupler while maintaining the quality of these transmitted signals.

### BRIEF DESCRIPTION OF DRAWINGS

FIG. 1 is an exploded perspective view of an electromagnetic resonance coupler according to Embodiment 1.
FIG. 2 is a plan view of a first transmission line and a second transmission line.
FIG. 3 is a cross-sectional view taken along the line III-III in FIG. 2.
FIG. 4 is a circuit block diagram of an electromagnetic resonance coupler according to a comparative example.
FIG. 5 is a circuit block diagram of the electromagnetic resonance coupler according to Embodiment 1.
FIG. 6 illustrates results of simulating frequency dependence of transmission characteristics and isolation characteristics of the electromagnetic resonance couplers according to the comparative example and Embodiment 1.
FIG. 7 is a block diagram illustrating a configuration of a gate drive device according to Embodiment 1.
FIG. 8 illustrates potential changes of a half bridge circuit and a power semiconductor device included in the gate drive circuit illustrated in FIG. 7.
FIG. 9 illustrates output characteristics of a gate drive circuit according to a comparative example.
FIG. 10 illustrates output characteristics of the gate drive circuit according to Embodiment 1.
FIG. 11 is an exploded perspective view of an electromagnetic resonance coupler according to Variation 1.
FIG. 12 is an exploded perspective view of an electromagnetic resonance coupler according to Variation 2.
FIG. 13 is a plan view of an electromagnetic resonance coupler according to Variation 3.
FIG. 14 is a plan view illustrating a layout structure for each layer of the electromagnetic resonance coupler illustrated in FIG. 13.
FIG. 15 is an example of a circuit block diagram of an electromagnetic resonance coupler according to Variation 4.
FIG. 16 is another example of the circuit block diagram of the electromagnetic resonance coupler according to Variation 4.
FIG. 17 is a functional block diagram of a signal transmission device according to Embodiment 2.

### DESCRIPTION OF EXEMPLARY EMBODIMENTS

An electromagnetic resonance coupler according to an aspect of the present disclosure is an electromagnetic resonance coupler that transmits a plurality of signals independently between a plurality of transmission lines, and includes at least: a first transmission line; a second transmission line; a first dielectric layer having a top surface on which the first transmission line is disposed; and a second dielectric layer disposed above and apart from the first dielectric layer, and having a back surface on which the second transmission line is disposed. The first transmission line includes: a first resonance line shaped in a loop and having a first opening; a second resonance line shaped in a loop and having a second opening; a first input-output line extending from the first resonance line; and a second input-output line extending from the second resonance line. The first resonance line and the second resonance line are disposed apart from each other on the top surface of the first dielectric layer. The second transmission line includes: a third resonance line shaped in a loop and having a third opening; a fourth resonance line shaped in a loop and having a fourth opening; a third input-output line extending from the third resonance line; and a fourth input-output line extending from the fourth resonance line. The third resonance line and the fourth resonance line are disposed apart from each other on the back surface of the second dielectric layer. The first resonance line and the third resonance line are disposed to overlap each other in plan view, and the second resonance line and the fourth resonance line are disposed to overlap each other in plan view. One of the first dielectric layer and the second dielectric layer includes a third ground part connected to the third resonance line via a third connector. One of the first dielectric layer and the second dielectric layer includes a fourth ground part connected to the fourth resonance line via a fourth connector. The third ground part and the fourth ground part are separated from each other.

With this configuration, the third ground part where the third resonance line is grounded and the fourth ground part where the fourth resonance line is grounded are separated from each other. This reduces signal leakage between the third input-output line and the fourth input-output line.

One of the first dielectric layer and the second dielectric layer may include a first ground part connected to the first resonance line via a first connector, one of the first dielectric layer and the second dielectric layer may include a second ground part connected to the second resonance line via a second connector.

With this configuration, the first ground part where the first resonance line is grounded and the second ground part where the second resonance line is grounded are also separated from each other. This reduces signal leakage between the first input-output line and the second input-output line.

The first resonance line and the second resonance line connected together on the top surface of the first dielectric layer may be connected to a fifth ground part included in one of the first dielectric layer and the second dielectric layer, via at least one of a first connector and a second connector included in one of the first dielectric layer and the second dielectric layer.

This configuration reduces signal leakage between the input-output lines, and achieves signal transmission with low loss.

Preferably, the first to fourth connectors are connected respectively to one end of the first to fourth resonance lines.

Preferably, a contour of the first resonance line substantially matches a contour of the third resonance line in plan view, and a contour of the second resonance line substantially matches a contour of the fourth resonance line in plan view.

This configuration increases the electromagnetic resonance coupling efficiency between the first resonance line and the third resonance line, and between the second resonance line and the fourth resonance line. Thus, the signal transmission efficiency increases.

Preferably, contours of the first resonance line and the second resonance line are surrounded by a first ground line on the top surface of the first dielectric layer, and contours of the third resonance line and the fourth resonance line are surrounded by a second ground line on the back surface of the second dielectric layer.

This configuration stabilizes the potentials of the first and second ground lines, enhancing the effect of shielding the first to fourth resonance lines in the first and second transmission lines.

Preferably, the first ground line is connected to at least one of a first ground part and a second ground part via a fifth connector, and the second ground line is connected to at least one of the third ground part and the fourth ground part via a sixth connector.

This configuration further enhances the effect of shielding the first to fourth resonance lines in the first and second transmission lines.

An insulated gate drive circuit according to an aspect of the present disclosure is a gate drive circuit that is an insulated gate drive circuit and drives a semiconductor switching element, and includes: a modulator circuit that generates: a first modulated signal by modulating a high-frequency signal in response to an input signal; and a second modulated signal by modulating the high-frequency signal in response to an input signal different from the input signal used for the first modulated signal; a first electromagnetic resonance coupler that transmits the high-frequency signal and the first modulated signal in an electrically insulated manner; a second electromagnetic resonance coupler that transmits the second modulated signal in the electrically insulated manner; a first rectifier circuit that generates a first signal by rectifying the first modulated signal transmitted in the electrically insulated manner from the first electromagnetic resonance coupler; a second rectifier circuit that generates a second signal by rectifying the second modulated signal transmitted in the electrically insulated manner from the second electromagnetic resonance coupler; a third rectifier circuit that generates a charging voltage by rectifying the high-frequency signal transmitted in the electrically insulated manner from the first electromagnetic resonance coupler; a capacitor charged in accordance with the charging voltage; and an output circuit that selects, in accordance with at least one of the first signal and the second signal, whether to supply electricity charged in the capacitor to a gate terminal of the semiconductor switching element. The first electromagnetic resonance coupler is a gate drive circuit operating as the above-described electromagnetic resonance coupler.

This configuration reduces signal leakage in the first electromagnetic resonance coupler, achieving favorable output characteristics of the semiconductor switching element.

Preferably, the output circuit is a half bridge circuit including: a first switching element on a high side; and a second switching element connected in series with the first switching element on a low side, the first rectifier circuit is connected to a control terminal of the second switching element, and the second rectifier circuit is connected to a control terminal of the first switching element.

With this configuration, the first switching element having the unstable potential on the ground side is connected independently to the electromagnetic resonance coupler and the rectifier circuit. This stabilizes the potential of the first switching element and maintains the operating characteristics of the half bridge circuit.

A signal transmission device according to an aspect of the present disclosure includes: a signal transmitter that transmits a plurality of signals; a signal transmission part that transmits the plurality of signals independently; and a signal receiver that receives the plurality of signals transmitted independently. The signal transmission part is a signal transmission device including the above-described electromagnetic resonance coupler.

This configuration reduces signal leakage between the terminals of the electromagnetic resonance coupler, and enables the signal transmission device to favorably transmit the signals.

The following is a detailed description of embodiments according to the present disclosure, with reference to the drawings. It should be noted that each of the preferred embodiments below describes only an example in nature and thus is not intended to limit the present disclosure or its application or uses. Note that numerical values, shapes, materials, components, locations and connection states of the components, and so forth described in the embodiments below are only examples and are not intended to limit the present disclosure. Among the components described in the embodiments below, the components that are not recited in any one of the independent claims indicating top concepts according to the present disclosure are described as arbitrary components.

Note that each of the drawings is a schematic diagram and not necessarily represent any physical likeness. Moreover, substantially same components are assigned the same reference marks throughout the drawings. To avoid repetition, the descriptions on these components may be omitted or simplified.

### EMBODIMENT 1

### [Overall Configuration of Electromagnetic Resonance Coupler]

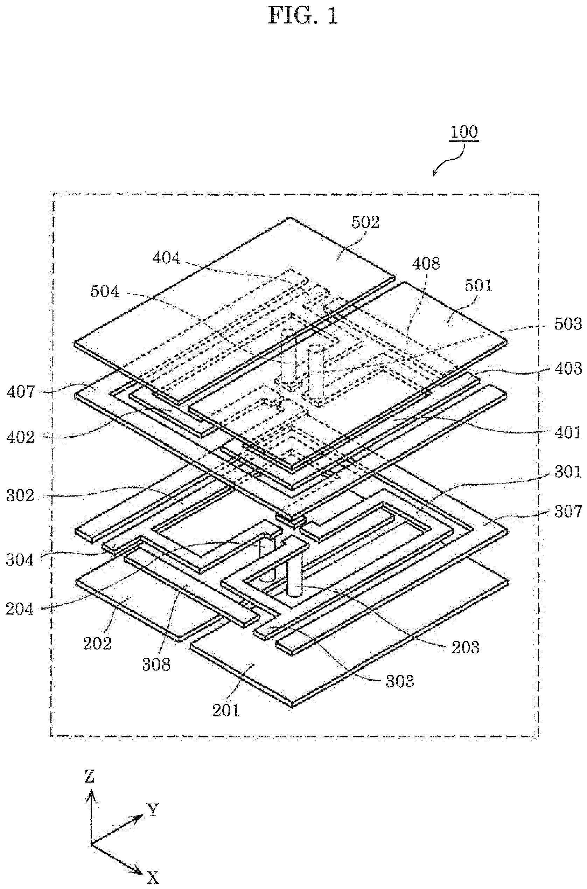

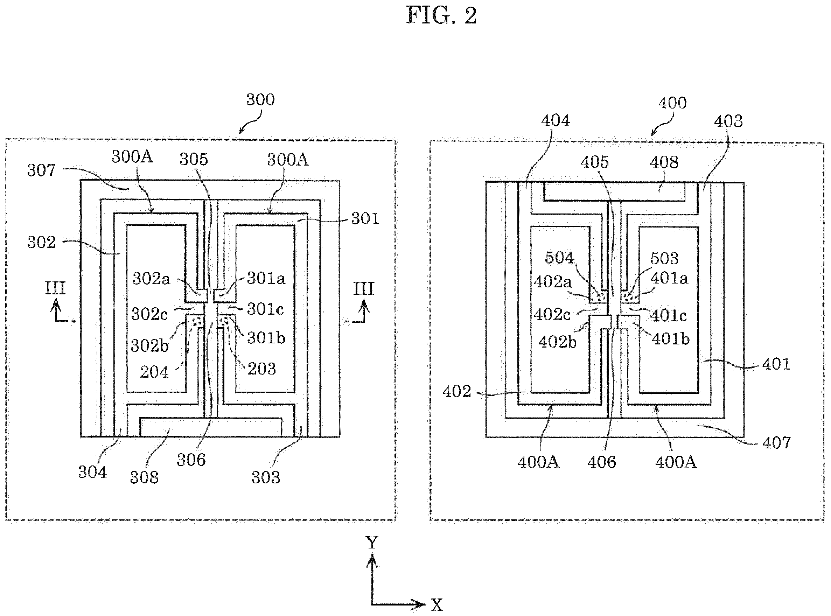

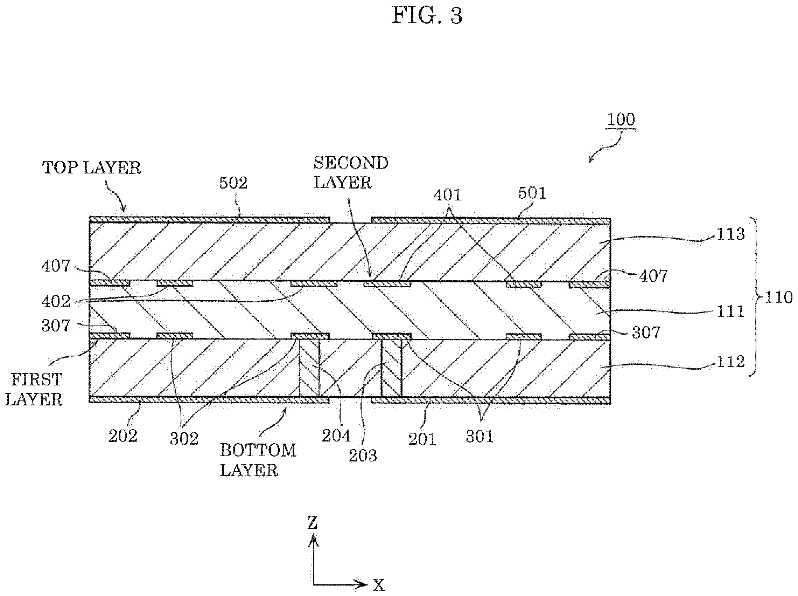

FIG. 1 is an exploded perspective view of the electromagnetic resonance coupler according to the present embodiment. FIG. 2 is a plan view of a first transmission line and a second transmission line of the electromagnetic resonance coupler according to the present embodiment. FIG. 3 is a cross-sectional view taken along the line III-III in FIG. 2. For the purpose of illustration, dielectric layers 111 to 113 are omitted from FIG. 1 and FIG. 2.

Electromagnetic resonance coupler 100 includes: substrate 110 having three laminated dielectric substrates, or more specifically, dielectric layers 111 to 113; first transmission line 300 disposed on a top surface of dielectric layer 112 (first dielectric layer); and second transmission line 400 disposed on a back surface of dielectric layer 113 (second dielectric layer). Dielectric layer 111 is interposed between dielectric layer 112 (first dielectric layer) and dielectric layer 113 (second dielectric layer).

Back-side ground 201 (first ground part) and back-side ground 202 (second ground part) are disposed on a back surface of substrate 110, that is, on a back surface of dielectric layer 112 (first dielectric layer) in the present embodiment. Back-side grounds 201 and 202 are disposed apart and separated from each other in an X direction.

Cover ground 501 (third ground part) and cover ground 502 (fourth ground part) are disposed on a top surface of substrate 110, that is, on a top surface of dielectric layer 113 (second dielectric layer). Cover ground 501 (the third ground part) and cover ground 502 (fourth ground part) are disposed apart and separated from each other in the X direction.

Note that a direction in which cover grounds 501 and 502 are arranged may be referred to as the X direction in the present embodiment. Moreover, a direction perpendicular to the X direction and parallel to the top surface of substrate 110 may be referred to as a Y direction. Furthermore, a direction perpendicular to the X and Y directions and in which dielectric layers 111 and 113 are laminated may be referred to as a Z direction. Note also that locations of cover grounds 501 and 502 may be described as being "upper" and that locations of back-side grounds 201 and 202 may be described as being "lower". Cover grounds 501 and 502 may be referred to as a "top layer". Third resonance line 401 and fourth resonance line 402 described later may be referred to as a "second layer". First resonance line 301 and second resonance line 302 described later may be referred to as a "first layer". Back-side ground 201 and back-side ground 202 may be referred to as a "bottom layer".

Each of dielectric layers (dielectric substrates) 111 to 113 is a sapphire substrate, for example. Alternatively, each of these layers may include a polyphenylene ether resin (PPE resin) filled with high-dielectric-constant inorganic filler. A material typically used for making a printed substrate may be used as a constituent material of dielectric layers 111 to 113. The constituent material is not limited to the above.

First transmission line 300 is disposed on the top surface of dielectric layer 112 and includes: first resonance line 301 substantially rectangular and having first end part 301a, second end part 301b, and first opening 301c; and second resonance line 302 substantially rectangular and having first end part 302a, second end part 302b, and second opening 302c. Additionally, first transmission line 300 includes: first input-output line (input-output terminal) 303 extending outward from a point along first resonance line 301 in the Y direction; and second input-output line (input-output terminal) 304 extending outward from a point along second resonance line 302 in the Y direction, and disposed apart from first input-output line 303.

First end part 301a and second end part 301b of first resonance line 301 are disposed apart from each other in the Y direction and opposite to each other. First end part 302a and second end part 302b of second resonance line 302 are disposed apart from each other in the Y direction and opposite to each other. First end part 301a of first resonance line 301 and first end part 302a of second resonance line 302 are disposed apart from each other in the X direction and opposite to each other. Second end part 301b of first resonance line 301 and second end part 302b of second resonance line 302 are disposed apart from each other in the X direction and opposite to each other. A space between first end part 301a and second end part 301b of first resonance line 301 in the Y direction is first opening 301c. A space between first end part 302a and second end part 302b of second resonance line 302 in the Y direction is second opening 302c.

Suppose that first resonance line 301 and second resonance line 302 are viewed as a single line, resonance line part 300A. In this case, resonance line part 300A is a loop-shaped line that is partially open by: opening 305 between first end part 301a and first end part 302a; and opening 306 between second end part 301b and second end part 302b.

Second end part 301b of first resonance line 301 is electrically connected to back-side ground 201 (first ground part) via first connector 203 penetrating dielectric layer 112. First connector 203 is a conductive via made of a metal, such as copper. Second end part 302b of second resonance line 302 is electrically connected to back-side ground 202 (second ground part) via second connector 204 penetrating dielectric layer 112. Second connector 204 is a conductive via made of a metal, such as copper.

First coplanar ground 307 (first ground line) is disposed around and apart from first resonance line 301 and second resonance line 302, on the top surface of dielectric layer 112 (first dielectric layer). Second coplanar ground 308 is disposed between and apart from first input-output line 303 and second input-output line 304, and extends in the X direction. First coplanar ground 307 and second coplanar ground 308 are also located on the first layer.

Second transmission line 400 is disposed on the back surface of dielectric layer 113 and includes: third resonance line 401 substantially rectangular and having first end part 401a, second end part 401b, and third opening 401c; and fourth resonance line 402 substantially rectangular and having first end part 402a, second end part 402b, and fourth opening 402c. Additionally, second transmission line 400 includes: third input-output line (input-output terminal) 403 extending outward from a point along third resonance line 401 in the Y direction; and fourth input-output line (input-output terminal) 404 extending outward from a point along fourth resonance line 402 in the Y direction, and disposed apart from third input-output line 403.

First end part 401a and second end part 401b of third resonance line 401 are disposed apart from each other in the Y direction and opposite to each other. First end part 402a and second end part 402b of fourth resonance line 402 are disposed apart from each other in the Y direction and opposite to each other. First end part 401a of third resonance line 401 and first end part 402a of fourth resonance line 402 are disposed apart from each other in the X direction and opposite to each other. Second end part 401b of third resonance line 401 and second end part 402b of fourth resonance line 402 are disposed apart from each other in the X direction and opposite to each other. A space between first end part 401a and second end part 401b of third resonance line 401 in the Y direction is third opening 401c. A space between first end part 402a and second end part 402b of fourth resonance line 402 in the Y direction is fourth opening 402c.

Suppose that third resonance line 401 and fourth resonance line 402 are viewed as a single line, resonance line part 400A. In this case, resonance line part 400A is a loop-shaped line that is partially open by: opening 405 between first end part 401a and first end part 402a; and opening 406 between second end part 401b and second end part 402b.

Second end part 401b of third resonance line 401 is electrically connected to cover ground 501 (third ground part) via third connector 503 penetrating dielectric layer 113. Third connector 503 is a conductive via made of a metal, such as copper. Second end part 402b of fourth resonance line 402 is electrically connected to cover ground 502 (fourth ground part) via fourth connector 504 penetrating dielectric layer 113. Fourth connector 504 is a conductive via made of a metal, such as copper.

Third coplanar ground 407 (second ground line) is disposed around and apart from third resonance line 401 and fourth resonance line 402, on the back surface of dielectric layer 113 (second dielectric layer). Fourth coplanar ground 408 is disposed between and apart from third input-output line 403 and fourth input-output line 404, and extends in the X direction. Third coplanar ground 407 and fourth coplanar ground 408 are also located on the second layer.

A line length of first resonance line 301, or more specifically, a length from first end part 301a to second end part 301b, is designed to be one-quarter of a wavelength (hereinafter, also referred to as an operating wavelength) of a high-frequency signal (hereinafter, also referred to as a transmission signal) that is inputted to or outputted from first input-output line 303. This relationship between the line length and the operating wavelength of the transmission signal is similarly applied to second resonance line 302, third resonance line 401, and fourth resonance line 402.

When substrate 110 is viewed from the Z direction, that is, viewed in plan view, a contour of first resonance line 301 generally matches a contour of third resonance line 401, and a contour of second resonance line 302 generally match a contour of fourth resonance line 402. Here, the contour of first resonance line 301 is defined by an outermost contour specifying a footprint of first resonance line 301.

The generally matching contours refer to contours that match substantially after allowing for manufacturing or assembly tolerance of dielectric layers 111 to 113 and for size variations of first resonance line 301, third resonance line 401, second resonance line 302, and fourth resonance line 402. Thus, the generally matching contours do not necessarily refer to the completely matching contours.

Even when the contours of first resonance line 301 and third resonance line 401 do not match or the contours of second resonance line 302 and fourth resonance line 402 do not match, electromagnetic resonance coupler 100 is operable. Electromagnetic resonance coupler 100 operates more effectively when the contours of first resonance line 301 and third resonance line 401 match and the contours of second resonance line 302 and fourth resonance line 402 match.

First resonance line 301 and second resonance line 302 are symmetrical about a point (or a line) in plan view in the present embodiment. Similarly, third resonance line 401 and fourth resonance line 402 are symmetrical about a point (or a line) in plan view.

Resonance line part 300A and resonance line part 400A may have the same axis (i.e., these resonance lines may share the same center point), for example. Contours of resonance line part 300A and resonance line part 400A may match in plan view, for example. Resonance line part 300A and resonance line part 400A are symmetrical about a point (or a line). This arrangement enhances the electromagnetic resonance coupling between first transmission line 300 and second transmission line 400, enabling efficient power transmission.

A distance between first transmission line 300 and second transmission line 400 in a direction of lamination, or more specifically, a distance corresponding to a thickness of dielectric layer 111, is one-half or less of the operating wavelength of the transmission signal. The wavelength referred to here reflects a wavelength reduction rate of dielectric layer 111 contacting first transmission line 300 and second transmission line 400. Under such a condition, electromagnetic resonance coupling is achieved between first transmission line 300 and second transmission line 400 in a near-field region.

The distance between first transmission line 300 and second transmission line 400 in the Z direction is not limited to one-half or less of the operating wavelength. Even when the distance between first transmission line 300 and second transmission line 400 in the Z direction is longer than one-half of the operating wavelength, electromagnetic resonance coupler 100 is operable. However, electromagnetic resonance coupler 100 operates more effectively when the distance between first transmission line 300 and second transmission line 400 in the Z direction is one-half or less of the operating wavelength.

As described above, first resonance line 301, second resonance line 302, third resonance line 401, and fourth resonance line 402 are substantially rectangular in plan view. However, the shapes are not particularly limited to this, and may be annular or polygonal other than rectangular. More specifically, each of the lines may be loop-shaped and partially open, for example.

### [Operation of Electromagnetic Resonance Coupler]

The following describes an operation of electromagnetic resonance coupler 100 in which a transmission signal inputted to first transmission line 300 is transmitted contactlessly to second transmission line 400 and then outputted from second transmission line 400. Here, the transmission signal is a modulated high-frequency signal at 1 MHz or higher, for example.

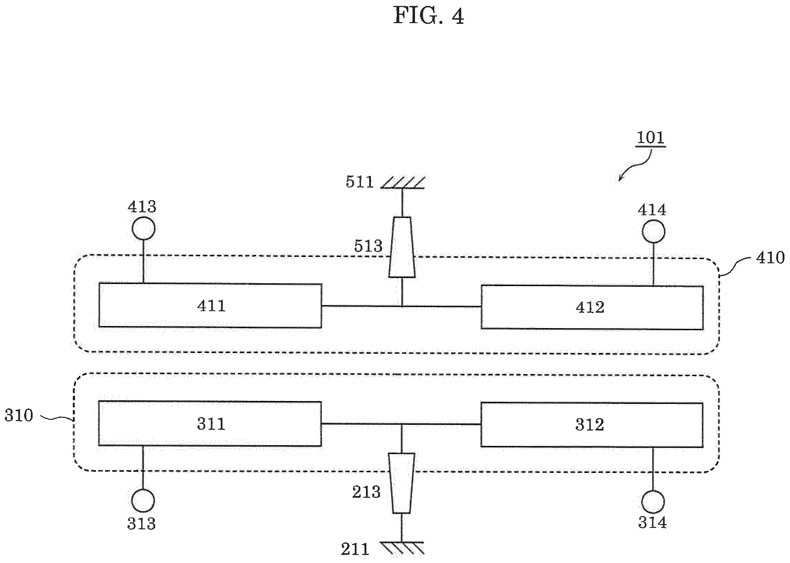

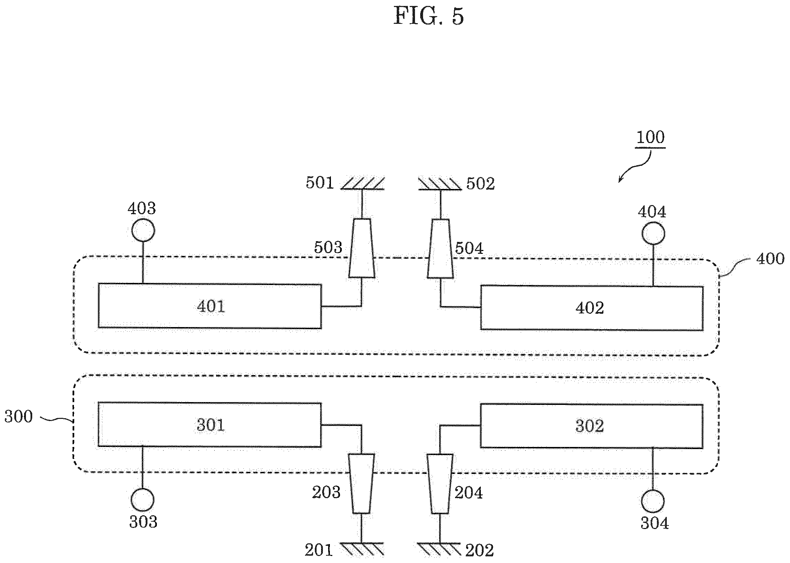

FIG. 4 is a circuit block diagram of an electromagnetic resonance coupler according to a comparative example. FIG. 5 is a circuit block diagram of the electromagnetic resonance coupler according to the present embodiment.

As illustrated in FIG. 5, the transmission signal inputted to first input-output line 303 is transmitted contactlessly from first resonance line 301 to third resonance line 401 through electromagnetic resonance coupling between first resonance line 301 and third resonance line 401, and then outputted from third input-output line 403.

Moreover, the transmission signal inputted to second input-output line 304 is transmitted contactlessly from second resonance line 302 to fourth resonance line 402 through electromagnetic resonance coupling between second resonance line 302 to fourth resonance line 402, and then outputted from fourth input-output line 404. In this way, electromagnetic resonance coupler 100 has a dual contactless transmission system.

FIG. 4 is a circuit block diagram of a conventional electromagnetic resonance coupler disclosed in PTL 3, for example. An input-output system for transmission signals is the same as the system illustrated in FIG. 5.

Electromagnetic resonance coupler 101 illustrated in FIG. 4 includes first transmission line 310 having first resonance line 311 and second resonance line 312 which are integrated with each other and each have an opening (not illustrated). First resonance line 311 and second resonance line 312 are connected to back-side ground 211 via first connector 213 disposed at a midpoint between first resonance line 311 and second resonance line 312. Moreover, second transmission line 410 has third resonance line 411 and fourth resonance line 412 which are also integrated with each other and each have an opening (not illustrated). Third resonance line 411 and fourth resonance line 412 are connected to cover ground 511 via third connector 513 disposed at a midpoint between third resonance line 411 and fourth resonance line 412. To be more specific, first resonance line 311 and second resonance line 312 are connected to the common back-side ground via the common connector, and first resonance line 311 and second resonance line 312 are connected to the common cover ground via the common connector. A total line length of first resonance line 311 and second resonance line 312 is one-half of the wavelength of the transmission signal. Each line length of first resonance line 311 and second resonance line 312 is designed to be one-quarter of the wavelength of the transmission signal. A total line length of third resonance line 411 and fourth resonance line 412 is one-half of the wavelength of the transmission signal. Each line length of third resonance line 411 and fourth resonance line 412 is designed to be one-quarter of the wavelength of the transmission signal.

For example, suppose that a high-power transmission signal is inputted to first input-output line 313 of electromagnetic resonance coupler 101 illustrated in FIG. 4. In this case, a large amount of current flows, via third connector 513, into cover ground 511 from third resonance line 411 receiving this transmission signal through electromagnetic resonance coupling with first resonance line 311. Because cover ground 511 is also connected to fourth resonance line 412, a signal resulting from this current leaks to fourth input-output line 414 via third connector 513 and fourth resonance line 412.

In contrast, first resonance line 301 and second resonance line 302 in electromagnetic resonance coupler 100 illustrated in FIG. 5 are separated from each other. Moreover, back-side ground 201 connected to first resonance line 301 via first connector 203 is separated from back-side ground 202 connected to second resonance line 302 via second connector 204. Thus, even when a high-power transmission signal is inputted to first input-output line 303 and current leaks, via third connector 503, to cover ground 501 from third resonance line 401 receiving this signal, this current does not leak to cover ground 502 in the shortest distance. This can reduce signal leakage to fourth input-output line 404.

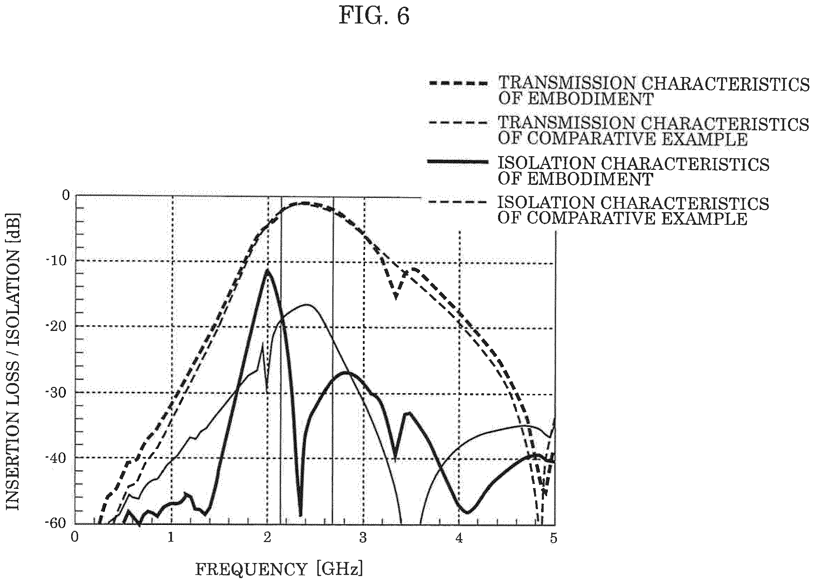

FIG. 6 illustrates results of simulating frequency dependence of transmission characteristics and isolation characteristics of the electromagnetic resonance couplers according to the comparative example and the present embodiment. Here, each of the electromagnetic resonance couplers according to the comparative example and the present embodiment is designed to have the maximum of insertion loss, which indicates the transmission characteristics, at a frequency of 2.4 GHz.

As illustrated in FIG. 6, electromagnetic resonance coupler 101 according to the comparative example and electromagnetic resonance coupler 100 according to the present embodiment have the same insertion loss, which is 1.0 dB, at 2.4 GHz. However, isolations indicating the isolation characteristics of these electromagnetic resonance couplers are significantly different over a range of 2.2 GHz to 2.7 GHz (between the solid lines in FIG. 6). The isolation of electromagnetic resonance coupler 101 is -18 dB at 2.4 GHz. In contrast, the isolation of electromagnetic resonance coupler 100 is -40 dB or higher at 2.4 GHz, which indicates significant enhancement in the isolation characteristics.

### [Configuration and Operating Characteristics of Gate Drive Circuit]

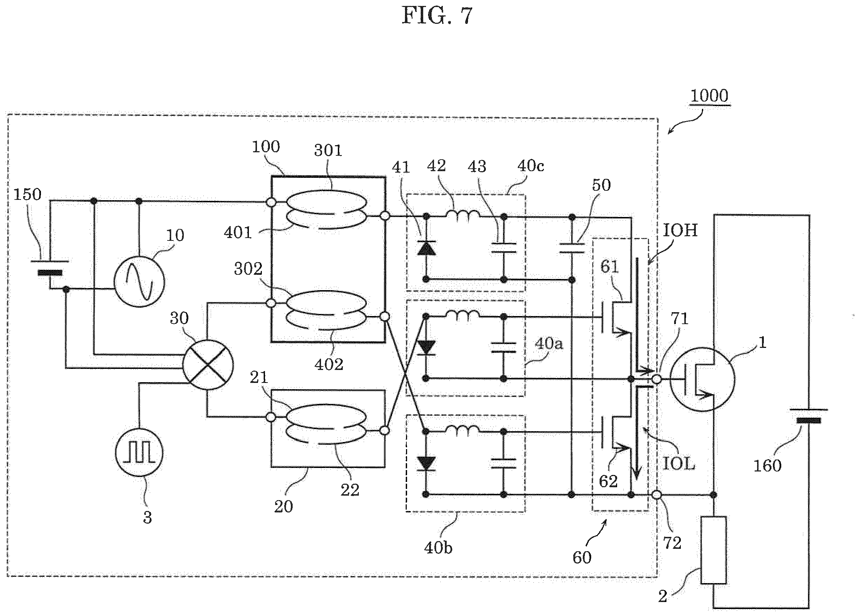

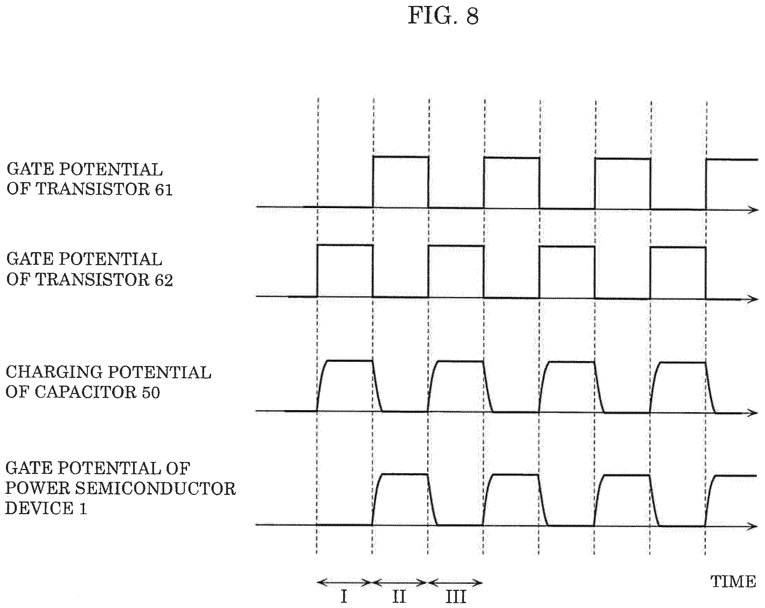

FIG. 7 is a schematic circuit diagram of the gate drive device according to the present embodiment. FIG. 8 illustrates potential changes of a half bridge circuit and a power semiconductor device included in the gate drive circuit illustrated in FIG. 7. Gate drive circuit 1000 includes direct-current power supply 150 and signal generator 3. Moreover, gate drive circuit 1000 includes high-frequency oscillator circuit 10, modulator circuit 30, first electromagnetic resonance coupler 100, and second electromagnetic resonance coupler 20. Furthermore, electromagnetic resonance coupler 1000 includes rectifier circuits 40a to 40c, capacitor 50, half bridge circuit 60 (output circuit), output terminal 71, and output reference terminal 72.

Gate drive circuit 1000 is an insulated gate drive circuit that drives power semiconductor device 1 (semiconductor switching element).

Power semiconductor device 1 is a semiconductor switching element having: a gate terminal (control terminal) connected to output terminal 71 of gate drive circuit 1000; and a source terminal connected to output reference terminal 72. To be more specific, power semiconductor device 1 is an insulated gate bipolar transistor (IGBT), a SiC field effect transistor (SiC FET), or a gallium nitride (GaN) transistor, for example. Power semiconductor device 1 is connected in series with load 2. More specifically, one end of load 2 is connected to the source terminal of power semiconductor device 1. A positive terminal of direct-current power supply 160 is connected to a drain terminal of power semiconductor device 1, and a negative terminal of direct-current power supply 160 is connected to the other end of load 2.

Direct-power supply 150 supplies power to enable high-frequency oscillator circuit 10 and modulator circuit 30 to operate. Direct-current power supply 150 is provided inside gate drive circuit 1000 in the configuration illustrated in FIG. 7. However, direct-current power supply 150 may be provided outside gate drive circuit 1000.

Signal generator 3 generates an input signal (control signal) to drive power semiconductor device 1, and outputs the input signal to modulator circuit 30. Signal generator 30 includes a logic IC, for example. The input signal is a binary signal with two levels, high and low.

Although signal generator 3 is provided inside gate drive circuit 1000, signal generator 3 may be provided outside gate drive circuit 1000. In this case, gate drive circuit 1000 additionally includes an input terminal (not illustrated) that receives the input signal from signal generator 3.

High-frequency oscillator circuit 10 generates a high-frequency signal. High-frequency oscillator circuit 10 includes at least a dual output system, and outputs the generated high-frequency signal to modulator circuit 30 and first electromagnetic resonance coupler 100. The high-frequency signal is in 2.4 GHz and 5.8 GHz ISM bands that require no license for low output power. However, the signal may be at other frequencies. More specifically, high-frequency oscillator circuit 10 is a Colpitts oscillator, a Hartley oscillator, or any other oscillator generating a microwave. High-frequency oscillator circuit 10 may include a frequency adjustment mechanism (not illustrated) in view of frequency fluctuation of the high-frequency signal, for example. The high-frequency signal generated by high-frequency oscillator circuit 10 has a predetermined amplitude and is at a predetermined frequency, in principle. Although high-frequency oscillator circuit 10 is provided inside gate drive circuit 1000, high-frequency oscillator circuit 10 may be provided outside gate drive circuit 1000. In this case, gate drive circuit 1000 additionally includes an input terminal (not illustrated) that receives the high-frequency signal.

Modulator circuit 30 generates a first modulated signal by modulating the high-frequency signal in accordance with the input signal outputted from signal generator 3, and then outputs the first modulated signal to first electromagnetic resonance coupler 100. More specifically, modulator circuit 30 generates the first modulated signa by mixing the aforementioned input signal and high-frequency signal. Moreover, modulator circuit 30 generates a second modulated signal by modulating the high-frequency signal in accordance with an input signal outputted from signal generator 3 but different from the input signal used for generating the first modulated signal. Then, modulator circuit 30 outputs the second modulated signal to second electromagnetic resonance coupler 20. More specifically, modulator circuit 30 generates the second modulated signal by mixing a signal obtained by inverting the input signal received from signal generator 3 and the high-frequency signal received from high-frequency oscillator circuit 10. The first modulated signal and the second modulated signal maintain a complementary relationship when outputted. However, signal waveforms of these signals may be adjusted according to a drive condition.

Modulator circuit 30 is a so-called differential mixer (mixer circuit). The differential mixer is capable of modulating the high-frequency signal with low loss and including a plurality of input-output terminals, and thus is suitable for gate drive circuit 1000. Here, modulator circuit 30 may be a switch circuit. When a switch circuit is used as the modulator circuit, the switch circuit switches between outputting the high-frequency signal to first electromagnetic resonance coupler 100 and outputting the high-frequency signal to second electromagnetic resonance coupler 20, in accordance with the input signal. With this, the switch circuit generates the first modulated signal obtained by modulating the high-frequency signal and the second modulated signal obtained by modulating the high-frequency signal. In this case, the input signal is a complementary signal, for example. Such a signal is generated by signal generator 3 including the logic IC manufactured using a Si-CMOS or a compound semiconductor. The input signal may be, for example, a PWM signal having a non-constant duty cycle. The switch circuit used as modulator circuit 30 enhances isolation between the output terminals of modulator circuit 30. Because no matching circuit, such as an inductor, is required, gate drive circuit 1000 can be downsized.

First electromagnetic resonance coupler 100 has the same configuration as illustrated in FIG. 1 to FIG. 3 and FIG. 5. The high-frequency signal inputted from high-frequency oscillator circuit 10 to first input-output line 303 is transmitted in an electrically insulated manner from first resonance line 301 to third resonance line 401 contactlessly through electromagnetic resonance coupling, and then outputted from third input-output line 403. The first modulated signal inputted from modulator circuit 30 to second input-output line 304 is transmitted in the electrically insulated manner from second resonance line 302 to fourth resonance line 402 contactlessly through electromagnetic resonance coupling, and then outputted from fourth input-output line 404.

Second electromagnetic resonance coupler 20 includes resonance lines 21 and 22, each of which has one end connected to a back-side ground (not illustrated) and is substantially rectangular and partially open. The second modulated signal inputted from modulator circuit 30 to an input line (not illustrated) of second electromagnetic resonance coupler 20 is transmitted in the electrically insulated manner from resonance line 21 to resonance line 22 contactlessly through electromagnetic resonance coupling, and then outputted from an output line (not illustrated). Each line length of resonance lines 21 and 22 is designed to be one-quarter of the wavelength of the transmission signal.

Rectifier circuit 40c (third rectifier circuit) includes diode 41, inductor 42, and capacitor 43. In rectifier circuit 40c, a connection point between one end of inductor 42 and a cathode of diode 41 is connected to third input-output line 403 of first electromagnetic resonance coupler 100 and receives the high-frequency signal. This high-frequency signal is transmitted from high-frequency oscillator circuit 10 via first electromagnetic resonance coupler 100. The input high-frequency signal is rectified by rectifier circuit 40c and outputted as a third signal from a connection point between inductor 42 and capacitor 43. The output third signal charges capacitor 50. Capacitor 50 functions as a power supply that supplies drive power to half bridge circuit 60 described later. The high-frequency signal used for charging capacitor 50 requires a relatively large power of at least 20 dBm, for example.

Each of internal circuit configurations of rectifier circuit 40a (first rectifier circuit) and rectifier circuit 40b (second rectifier circuit) is the same as that of rectifier circuit 40c (third rectifier circuit). Rectifier circuit 40a (first rectifier circuit) is connected to fourth input-output line 404 of first electromagnetic resonance coupler 100 and receives the first modulated signal. The first modulated signal is rectified in rectifier circuit 40a (first rectifier circuit) and then inputted as a first signal to a gate terminal (control terminal) of transistor 62 (second switching element) of half bridge circuit 60 (output circuit). The second modulated signal is inputted from second electromagnetic resonance coupler 20 to rectifier circuit 40b (second rectifier circuit). The second modulated signal is rectified in rectifier circuit 40b (second rectifier circuit) and then inputted as a second signal to a gate terminal (control terminal) of transistor 61 (first switching element) of half bridge circuit 60 (output circuit).

Each of the output terminals of rectifier circuits 40a to 40c is adjusted to be a short-circuit point for high frequencies by inductor 42 and capacitor 43. Thus, the signals inputted from the input terminals of rectifier circuits 40a to 40c are reflected near the output terminals of rectifier circuits 40a to 40c. As a result, each signal amplitude (voltage value) of the input terminals of rectifier circuits 40a to 40c is about twice as large as an amplitude (voltage value) of the signal inputted from first electromagnetic resonance coupler 100 or second electromagnetic resonance coupler 20. This configuration enables rectifier circuits 40a to 40c to rectify the high frequency with high efficiency using single diode 41.

Even when the output terminals of rectifier circuits 40a to 40c are not precisely the short-circuit points for high frequencies, the output terminals functioning as low-pass filters at a predetermined frequency enable rectifier circuits 40a to 40c to perform rectification with high efficiency.

Half bridge circuit 60 (output circuit) includes transistor 61 (first switching element) and transistor 62 (second switching element). Transistor 61 supplies electricity charged in capacitor 50 to the gate terminal (control terminal) of power semiconductor device 1 in accordance with the second signal outputted from rectifier circuit 40b. Transistor 62 draws the electricity from the gate terminal of power semiconductor device 1 in accordance with the first signal outputted from rectifier circuit 40a. More specifically, half bridge circuit 60 selects, in accordance with the input signal, whether to supply the electricity charged in capacitor 50, that is, the drive power, to the gate terminal (control terminal) of power semiconductor device 1.

Here, the second signal is inputted via rectifier circuit 40b to transistor 61 located on the high side of half bridge circuit 60, from second electromagnetic resonance coupler 20 provided separately from first electromagnetic resonance coupler 100. Moreover, the first signal is inputted to transistor 62 located on the low side of half bridge circuit 60 from first electromagnetic resonance coupler 100 via rectifier circuit 40a. This is because the grounds for transistor 62 on the low side and transistor 61 on the high side need to be separated due to unstable potential of transistor 61 on the ground side. In the present embodiment, second electromagnetic resonance coupler 20 connected to transistor 61 and first electromagnetic resonance coupler 100 connected to transistor 62 are physically separate. Suppose that the potential of transistor 61 on the ground side becomes unstable but this has no significant effect on the output characteristics of gate drive circuit 1000. In this case, the first signal may be inputted from first electromagnetic resonance coupler 100 to transistor 61 via rectifier circuit 40a, and the second signal may be inputted to transistor 62 from second electromagnetic resonance coupler 20 via rectifier circuit 40b, for example.

In period I illustrated in FIG. 8, the second signal is inputted to the gate terminal (control terminal) of transistor 61 (first switching element), and the first signal is not inputted to the gate terminal (control terminal) of transistor 62 (second switching element). In this state, although electricity is charged in capacitor 50, transistor 61 is off. As a result, no current is supplied to power semiconductor device 1, which thus becomes non-conducting.

In period II, the second signal is not inputted to the gate terminal of transistor 61, and the first signal is inputted from rectifier circuit 40a to the gate terminal of transistor 62. As a result, the electricity charged in capacitor 50 is supplied to the gate terminal of power semiconductor device 1. Thus, power semiconductor device 1 becomes conducting, and current passes through load 2.

In period III, once again, the second signal is inputted from rectifier circuit 40b to the gate terminal of transistor 61, and the first signal is not inputted to the gate terminal of transistor 62. As a result, capacitor 50 is charged again, and transistor 62 discharges the electricity accumulated in the gate terminal of power semiconductor device 1 to output reference terminal 72. Thus, power semiconductor device 1 becomes non-conducting, and no current passes through load 2.

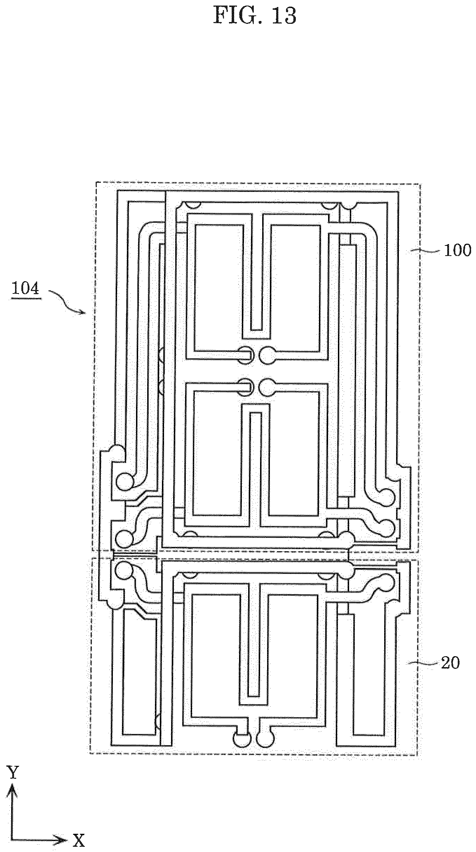

As disclosed in PTL 2, the insulated gate drive circuit, which is developed using the microwave driving technology, includes a transmission circuit, a reception circuit, and an electromagnetic resonance coupler. As illustrated in, for example, FIG. 13 disclosed in PTL 2, the same electromagnetic resonance coupler is used for transmitting the gate drive signal and transmitting the input signal to the charging capacitor. Here, separate transmissions of these signals may require the electromagnetic resonance coupler having the plurality of input-output terminals as disclosed in PTL 3, for example.

However, for this conventional electromagnetic resonance coupler having inadequate signal isolation between the input-output terminals (lines), a high-power high-frequency signal from the transmitting side can possibly leak to an unintended terminal. Such signal leakage to an unintended terminal can possibly occur not only to the aforementioned conventional gate drive circuit but also to any device transmitting signals of different systems using an electromagnetic resonance coupler having a plurality of input-output terminals.

In contrast, even when the high-power high-frequency signal is transmitted from high-frequency oscillator circuit 10 in the gate drive circuit according to the present embodiment illustrated in FIG. 7, signal leakage in first electromagnetic resonance coupler 100 is reduced. This results in favorable output characteristics.

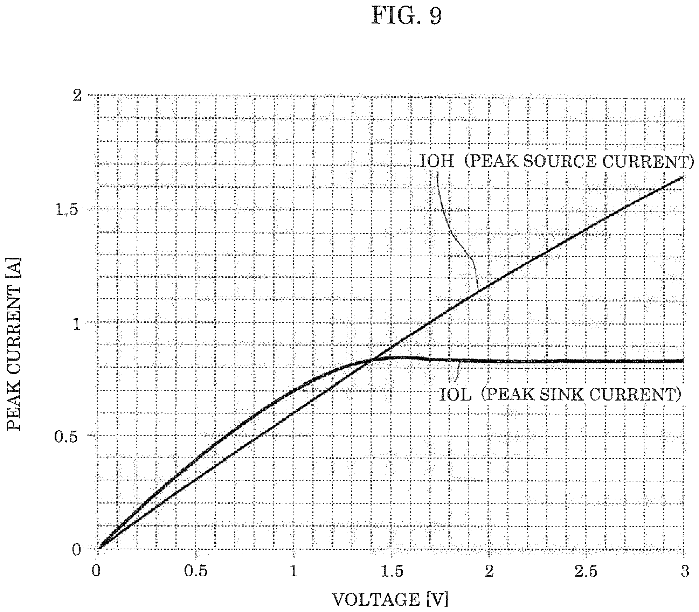

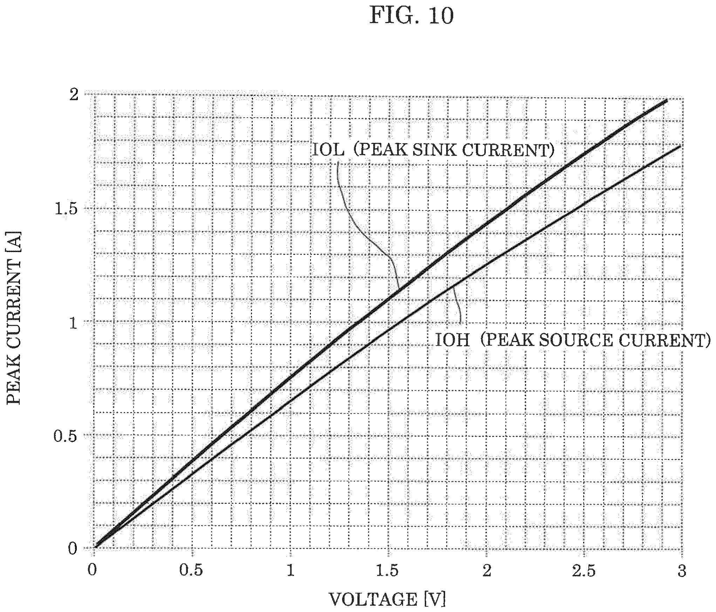

FIG. 9 illustrates output characteristics of a gate drive circuit according to a comparative example. FIG. 10 illustrates output characteristics of the gate drive circuit according to the present embodiment. The gate drive circuit according to the comparative example has the same configuration as illustrated in FIG. 7 except that electromagnetic resonance coupler 101 illustrated in FIG. 4 is used as first electromagnetic resonance coupler. Thus, descriptions on the configuration and operation are omitted.

For the gate drive circuit according to the comparative example, peak source current IOH passing through transistor 61 located on the high side of half bridge circuit 60 and then outputted to output terminal 71 of gate drive circuit 1000 increases linearly and is proportional to the voltage applied to the gate terminal of transistor 61, as shown in FIG. 9. In contrast, peak sink current IOL passing from output terminal 71 to transistor 62 located on the low side becomes saturated when the voltage applied to the gate terminal of transistor 62 reaches a fixed voltage, or more specifically, about 1.5 V or higher, as shown in FIG. 9. This results in a situation where the electricity charged in the gate terminal of power semiconductor device 1 cannot be drawn sufficiently.

The result of analyzing this situation by the inventors and others reveals that a voltage of about -1 V caused by the above signal leakage occurring to first electromagnetic resonance coupler 100 is superimposed at the gate terminal while transistor 62 is conducting.

In contrast, for gate drive circuit 1000 according to the present embodiment, both peak source current IOH and peak sink IOL increase linearly with the voltages applied to the gate terminals of transistors 61 and 62, as shown in FIG. 10. Thus, the above situation does not occur. This is because signal leakage to an unintended input-output line in first electromagnetic resonance coupler 100 is reduced adequately.

### [Advantageous Effects]

In electromagnetic resonance coupler 100 according to the present embodiment, first resonance line 301 and second resonance line 302 disposed apart from each other are connected respectively to back-side ground 201 and back-side ground 202 disposed apart from each other, respectively via first connector 203 and second connector 204. Moreover, third resonance line 401 and fourth resonance line 402 disposed apart from each other are connected respectively to cover ground 501 and cover ground 502 disposed apart from each other, respectively via third connector 503 and fourth connector 504. Thus, even when a high-power transmission signal is inputted to first input-output line 303 of first resonance line 301 and current leaks, via third connector 503, to cover ground 501 from third resonance line 401 receiving this signal, this current does not leak to cover ground 502 in the shortest distance. This can reduce signal leakage to fourth input-output line 404.

Moreover, for gate drive circuit 1000 according to the present embodiment, the first signal to drive transistor 61 (first switching element) of half bridge circuit 60 (output circuit) and the third signal to charge capacitor 50 serving as a power supply for half bridge circuit 60 can be transmitted from single electromagnetic resonance coupler 100 including the plurality of input-output lines 303, 304, 403, and 404. Additionally, leakage of the high-frequency signal inside electromagnetic resonance coupler 100 is reduced, which enhances the output current characteristics of insulated gate drive circuit 1000. The use of electromagnetic resonance coupler 100 outputting a plurality of signals can achieve downsizing of insulated gate drive circuit 1000.

### VARIATION 1

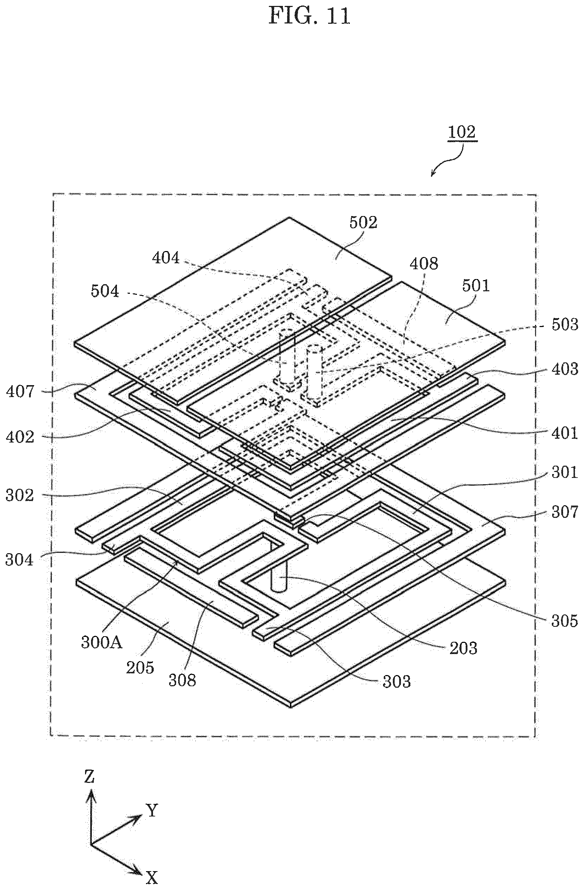

FIG. 11 is an exploded perspective view of an electromagnetic resonance coupler according to the present variation. For the purpose of illustration, dielectric layers 111 to 113 are omitted from FIG. 11.

Electromagnetic resonance coupler 102 according to the present variation is different from electromagnetic resonance coupler 100 illustrated in FIG. 1 to FIG. 3 in that second end part 301b of first resonance line 301 and second end part 302b of second resonance line 302 are connected to integrate first resonance line 301 and second resonance line 302. Suppose that first resonance line 301 and second resonance line 302 are viewed as a single line, resonance line part 300A. In this case, resonance line part 300A is a loop-shaped line that is partially open by opening 305 between end parts 301a and 302a. Moreover, back-side ground 201 and back-side ground 202 are connected into back-side ground 205 (fifth ground part) disposed on an entire back surface of dielectric layer 112 (first dielectric layer). Resonance line part 300A and back-side ground 205 are connected via first connector 203 penetrating dielectric layer 112 (first dielectric layer). Here, first connector 203 is connected at about a midpoint of resonance line part 300A in plan view. A line length from first end part 301a of resonance line part 300A to first connector 203 and a line length from second end part 302a of resonance line part 300A to first connector 203 are each designed to be one-quarter of the operating wavelength of the transmission signal.

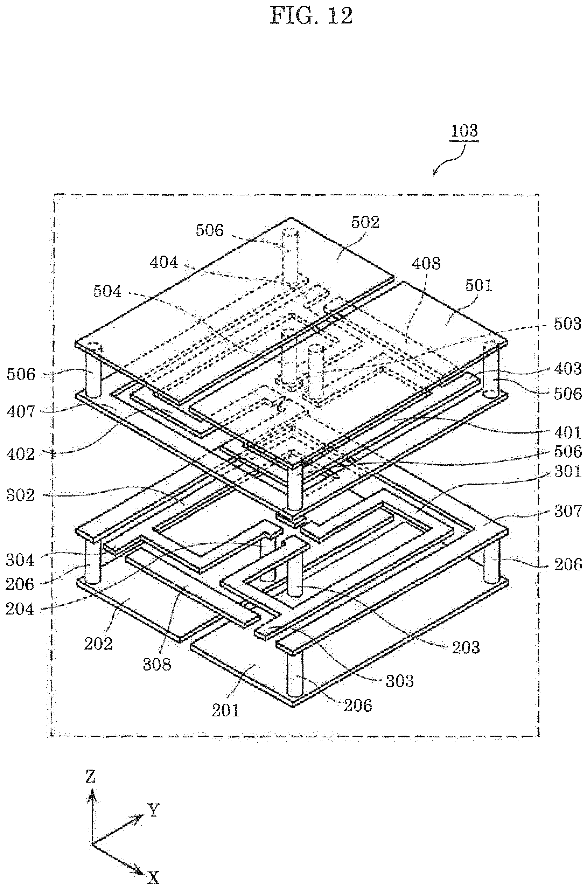

As a result of multiple studies of electromagnetic resonance coupler 100 having the configuration illustrated in FIG. 1 to FIG. 3, the inventors and others found out that signal leakage was caused mainly between the input-output lines used for outputting the transmission signal. When third input-output line 403 and fourth input-output line 404 were the output lines of the transmission signal, signal leakage was small between first input-output line 303 and second input-output line 304 used as the input lines. Thus, as illustrated in FIG. 12, the ground connected to first resonance line 301 having first input-output line 303 and the ground connected to second resonance line 302 having second input-output line 304 are integrated into back-side ground 205. Moreover, first resonance line 301 and second resonance line 302 are integrated into resonance line part 300A. This configuration achieves signal transmission in the electrically insulated manner with low loss. Here, resonance line part 300A and back-side ground 205 may be connected via second connector 204, or via both first connector 203 and second connector 204.

For the configuration in which the transmission signal is outputted from first input-output line 303 and second input-output line 304, cover ground 501 connected to third resonance line 401 and cover ground 502 connected to fourth resonance line 402 are integrated into a single cover ground. Moreover, third resonance line 401 and fourth resonance line 402 are integrated into resonance line part 400A. The integrated cover ground and resonance line part 400A are connected via third connector 503. Here, resonance line part 400A and the integrated cover ground may be connected via fourth connector 504, or via both third connector 503 and fourth connector 504.

### VARIATION 2

FIG. 12 is an exploded perspective view of an electromagnetic resonance coupler according to the present variation. For the purpose of illustration, dielectric layers 111 to 113 are omitted from FIG. 12.

Electromagnetic resonance coupler 103 according to the present variation is different from electromagnetic resonance coupler 100 illustrated in FIG. 1 to FIG. 3 in that first coplanar ground 307 (first ground line) disposed around first resonance line 301 and second resonance line 302 is connected to back-side grounds 201 and 202 via fifth connectors 206. Another difference is that third coplanar ground 407 (second ground line) disposed around third resonance line 401 and fourth resonance line 402 is connected to cover grounds 501 and 502 via sixth connectors 506.

First coplanar ground 307 is separated from first resonance line 301 and second resonance line 302. Third coplanar ground 407 is separated from third resonance line 401 and fourth resonance line 402. A potential of first coplanar ground 307 as well as potentials of back-side grounds 201 and 202 is a reference potential (ground potential) of first transmission line 300. Similarly, a potential of third coplanar ground 407 as well as potentials of cover ground 501 and 502 is a reference potential (ground potential) of second transmission line 400.

The configuration according to the present variation, in which first coplanar ground 307 is connected to back-side grounds 201 and 202 via fifth connectors 206, stabilizes the potential of first coplanar ground 307. This enhances the effect of shielding first resonance line 301 and second resonance line 302 against electromagnetic disturbances. Similarly, the connection between third coplanar ground 407 and cover grounds 501 and 502 via sixth connectors 506 stabilizes the potential of third coplanar ground 407. This enhances the effect of shielding third resonance line 401 and fourth resonance line 402 against electromagnetic disturbances. Electromagnetic resonance coupler 100 has a maximum electromagnetic field concentration near connectors 203, 204, 503, and 504. However, no signal leakage is caused between back-side grounds 201 and 202 connected to the connectors and disposed as the reference potential surface, because these grounds are separated at least in the same plane. Similarly, no signal leakage is caused between cover grounds 501 and 502 connected to the connectors and disposed as the reference potential surface, because these grounds are separated at least in the same plane.

### VARIATION 3

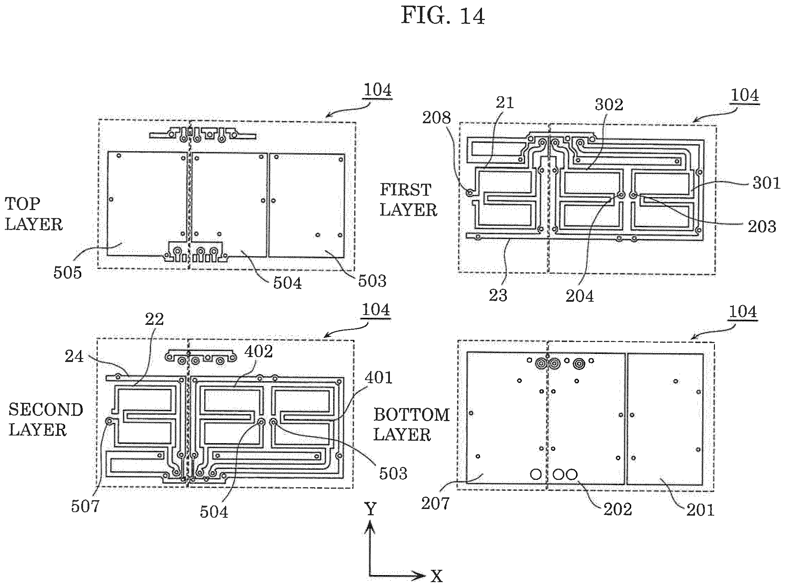

FIG. 13 is a plan view of an electromagnetic resonance coupler according to the present variation. FIG. 14 is a plan view illustrating a layout structure for each layer of the electromagnetic resonance coupler illustrated in FIG. 13. For the purpose of illustration, dielectric layers 111 to 113 are omitted from FIG. 13 and FIG. 14. Moreover, back-side grounds 201, 202, and 207 and cover grounds 501, 502, and 505 are omitted from FIG. 13.

Electromagnetic resonance coupler 104 illustrated in FIG. 13 includes electromagnetic resonance coupler 20 and electromagnetic resonance coupler 100 of gate drive circuit 1000 illustrated in FIG. 7, on the same substrate (the same dielectric layer). Electromagnetic resonance coupler 20 has: back-side ground 207 disposed on a back surface of dielectric layer 112 (first dielectric layer) and located as a bottom layer; resonance line 21 and coplanar ground 23 disposed on a top surface of dielectric layer 112 and located as a first layer; and connector 208 penetrating dielectric layer 112 (first dielectric layer) to connect back-side ground 207 and resonance line 21. Moreover, electromagnetic resonance coupler 20 has: cover ground 505 disposed on a top surface of dielectric layer 113 (second dielectric layer) and located as a top layer; resonance line 22 and coplanar ground 24 disposed on a back surface of dielectric layer 113 and located as a second layer; and connector 507 penetrating dielectric layer 113 (second dielectric layer) to connect cover ground 505 and resonance line 22. Although the layout structure of electromagnetic resonance coupler 100 is the same as in FIG. 12, each of electromagnetic resonance couplers 20 and 100 has input terminals (input lines) collectively on the left side in the X direction and output terminals (output lines) collectively on the right side in the X direction. This arrangement enables absolute signal isolation between the input terminals (input lines) and the output terminals (output lines). Back-side ground 207 of electromagnetic resonance coupler 20 and back-side ground 202 of electromagnetic resonance coupler 100 are integrated with each other. When a low-power signal is inputted to second input-output line 304, for example, signal leakage to electromagnetic resonance coupler 20 on the input side is almost negligible. For this reason, the back-side ground can be shared as described above. Back-side ground 207 and back-side ground 202 may be separated from each other.

Electromagnetic resonance coupler 100 and electromagnetic resonance coupler 20 are disposed on the same substrate, according to the present variation. This reduces signal leakage between the terminals, and achieves downsizing of electromagnetic resonance couplers. Additionally, favorable input-output characteristics of transmission signals can be obtained.

### VARIATION 4

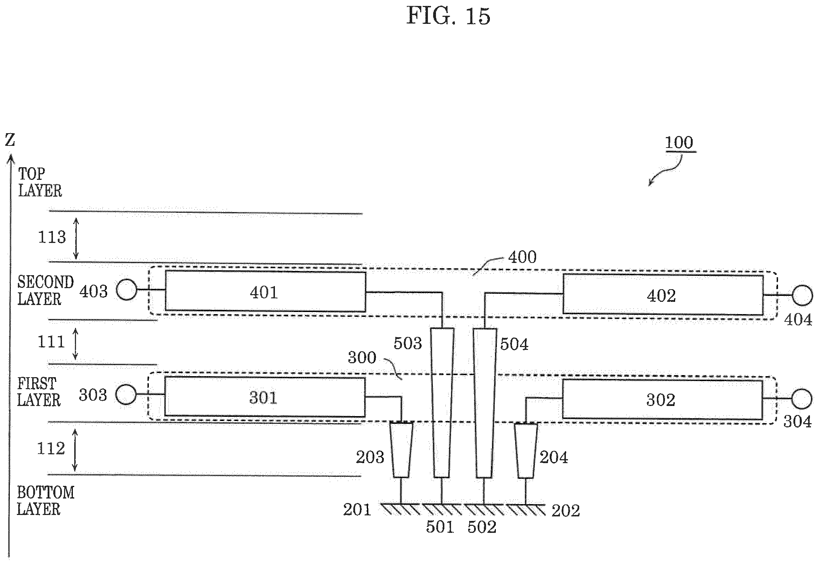

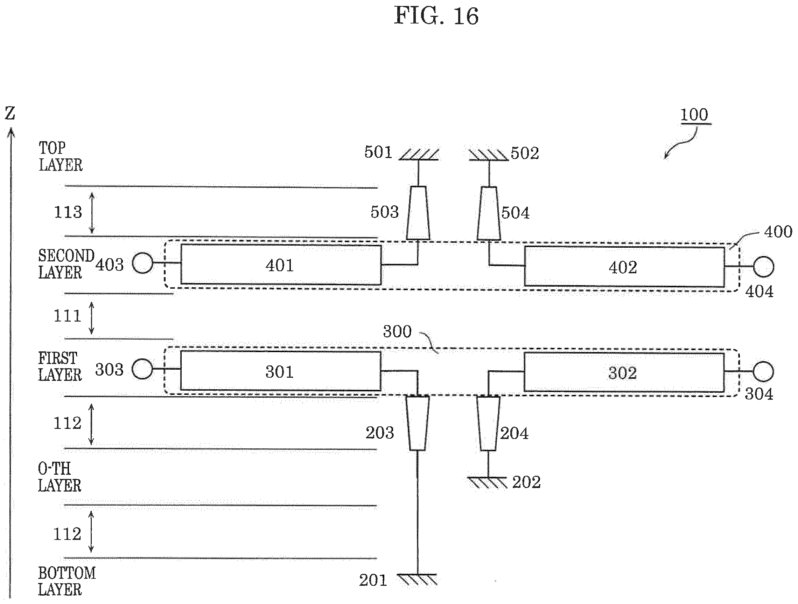

FIG. 15 is an example of a circuit block diagram of an electromagnetic resonance coupler according to the present variation. FIG. 16 is another example.

As illustrated in FIG. 15, cover ground 501 (third ground part) and cover ground 502 (fourth ground part) may be disposed on a back surface of dielectric layer 112 (first dielectric layer). In this case, third connector 503 and fourth connector 504 penetrate dielectric layers 111 and 112, and are connected respectively to cover ground 501 and cover ground 502. On the back surface of dielectric layer 112 (first dielectric layer), back-side ground 201, back-side ground 202, cover ground 501, and cover ground 502 are separated from each other. However, when first resonance line 301 and second resonance line 302 are connected to each other as illustrated in FIG. 11 for example, back-side ground 201 and back-side ground 202 may be connected together into back-side ground 205 as illustrated in FIG. 11. For example, the grounds connected to the input-output lines on the output side may be separated from each other. Moreover, back-side ground 201, back-side ground 202, cover ground 501, and cover ground 502 may be disposed on a top surface of dielectric layer 113 (second dielectric layer). In this case, first connector 203 and second connector 204 penetrate dielectric layers 111 and 113, and are connected respectively to back-side ground 201 and back-side ground 202. In this case too, back-side ground 201 and back-side ground 202 may be connected together into back-side ground 205 as illustrated in FIG. 11, for example.

As illustrated in FIG. 16, a 0th layer may be disposed in dielectric layer 112 (first dielectric layer), and back-side ground 202 may be disposed in this 0th layer. Similarly, back-side ground 201 may be disposed in this 0th layer. Although not illustrated, a third layer may be disposed as a line layer in dielectric layer 113 (second dielectric layer) and at least one of cover grounds 501 and 502 may be disposed in this third layer.

The above describes only an example. Back-side ground 201, back-side ground 202, cover ground 501, and cover ground 502 may be disposed on either dielectric layer 112 (first dielectric layer) or dielectric layer 113 (second dielectric layer), for example. Thus, the ground parts connected to the two resonance lines disposed in at least one of first transmission line 300 and second transmission line 400 may be separated from each other, for example.

### EMBODIMENT 2

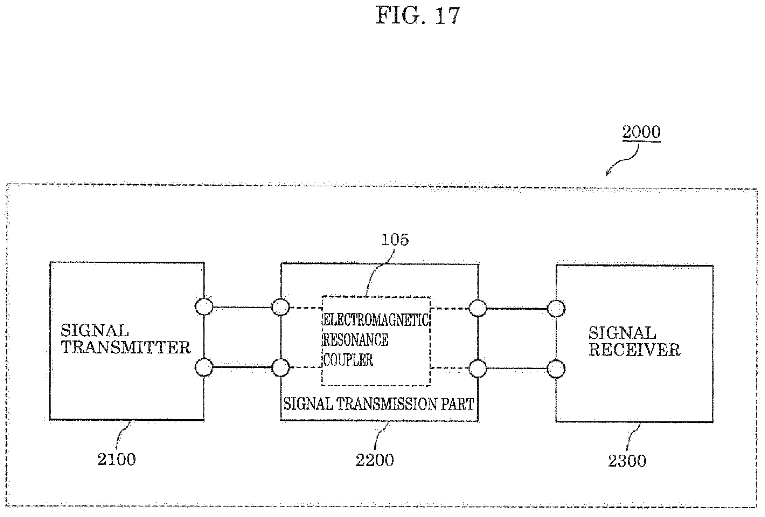

The electromagnetic resonance coupler according to Embodiment 1 described above is usable not only for an insulated gate drive circuit, but also for signal transmission devices in general capable of contactlessly transmitting a plurality of signals independently. FIG. 17 is a functional block diagram of a signal transmission device according to the present embodiment.

Signal transmitter 2100 sends a plurality of independent signals to signal transmission part 2200. Signal transmission part 2200 includes, for example, electromagnetic resonance coupler 100 according to Embodiment 1 and transmits the signal received from signal transmitter 2100 to signal receiver 2200 in the electrically insulated manner. Signal receiver 2200 receives the signal transmitted from signal transmission part 2200 in the electrically insulated manner.

Signal leakage can be reduced between the terminals of electromagnetic resonance coupler 100 according to the present embodiment. This can achieve favorable signal transmission without quality loss of the transmission signal. Note that the electromagnetic resonance coupler included in signal transmission part 2200 is not limited to electromagnetic resonance coupler 100 according to Embodiment 1. For example, electromagnetic resonance coupler 102 according to Variation 1, electromagnetic resonance coupler 103 according to Variation 2, or electromagnetic resonance coupler 104 according to Embodiment 2 may be used. Note also that the plurality of signals sent from signal transmitter 2100 may be sent at either the same time or different times.

### OTHER EMBODIMENTS

Although the technology disclosed in the present application has been described thus far by way of the embodiments above, it should be obvious that the present disclosure is not limited to the embodiments above. The present disclosure is applicable to other embodiments implemented through various changes, substitutions, additions, and omissions made as appropriate to the embodiments above. The present disclosure is also applicable to an embodiment implemented through a combination of the structural elements in different embodiments described above.

For example, each of the circuit configurations described in Embodiments 1 and 2 and Variations above is a merely an example. Other circuit configurations capable of implementing the functions described in Embodiments 1 and 2 may be used. The present disclosure includes, for example, a circuit configuration having a certain element connected to an element, such as a switching element (a transistor), a resistance element, or a capacitive element, in series or in parallel in a scope of achieving the functions similar to those of the circuit configurations above. More specifically, the term "connected" in the embodiments above refers to not only the state where two terminals (nodes) are directly connected to each other, but also the state where the two terminals (nodes) are connected via an element in the scope of achieving the functions similar to those of the circuit configurations above.

Although an electromagnetic resonance coupler and a transmission device in an aspect or aspects have been described by way of the embodiments above, it should be obvious that the present disclosure is not limited to the embodiments described above. Other embodiments implemented through various changes and modifications conceived by a person of ordinary skill in the art or through a combination of the structural elements in different embodiments described above may be included in the scope in an aspect or aspects according to the present disclosure, unless such changes, modifications, and combination depart from the scope of the present disclosure.

### INDUSTRIAL APPLICABILITY

The electromagnetic resonance coupler according to the present disclosure has favorable signal isolation characteristics between the terminals, and thus is applicable for an insulated gate drive circuit used for a motor drive circuit, for example.

### REFERENCE MARKS IN THE DRAWINGS

- 1: power semiconductor device (semiconductor switching element)
- 2: load
- 3: signal generator
- 10: high-frequency oscillator circuit
- 20: electromagnetic resonance coupler
- 30: modulator circuit
- 40a to 40c: rectifier circuit
- 50: capacitor
- 60: half bridge circuit (output circuit)
- 61: transistor (first switching element)
- 62: transistor (second switching element)
- 100, 102, 103, 104: electromagnetic resonance coupler
- 111: dielectric layer
- 112: dielectric layer (first dielectric layer)
- 113: dielectric layer (second dielectric layer)
- 201: back-side ground (first ground part)
- 202: back-side ground (second ground part)
- 203: first connector
- 204: second connector
- 205: back-side ground (fifth ground part)
- 206: fifth connector
- 300: first transmission line
- 301: first resonance line
- 301c: opening (first opening)
- 302: second resonance line
- 302c: opening (second opening)
- 303: first input-output line (input-output terminal)
- 304: second input-output line (input-output terminal)
- 307: first coplanar ground (first ground line)
- 400: second transmission line
- 401: third resonance line
- 401c: opening (third opening)
- 402: fourth resonance line
- 402c: opening (fourth opening)
- 403: third input-output line (input-output terminal)
- 404: fourth input-output line (input-output terminal)
- 407: third coplanar ground (second ground line)
- 501: cover ground (third ground part)
- 502: cover ground (fourth ground part)
- 503: third connector
- 504: fourth connector
- 506: sixth connector
- 1000: gate drive circuit
- 2000: signal transmission device

## Claims

1. An electromagnetic resonance coupler that transmits a plurality of signals independently between a plurality of transmission lines, the electromagnetic resonance coupler comprising at least:
a first transmission line;
a second transmission line;
a first dielectric layer having a top surface on which the first transmission line is disposed; and
a second dielectric layer disposed above and apart from the first dielectric layer, and having a back surface on which the second transmission line is disposed,
wherein the first transmission line includes: a first resonance line shaped in a loop and having a first opening; a second resonance line shaped in a loop and having a second opening; a first input-output line extending from the first resonance line; and a second input-output line extending from the second resonance line,
the first resonance line and the second resonance line are disposed apart from each other on the top surface of the first dielectric layer,
the second transmission line includes: a third resonance line shaped in a loop and having a third opening; a fourth resonance line shaped in a loop and having a fourth opening; a third input-output line extending from the third resonance line; and a fourth input-output line extending from the fourth resonance line,
the third resonance line and the fourth resonance line are disposed apart from each other on the back surface of the second dielectric layer,
the first resonance line and the third resonance line are disposed to overlap each other in plan view, and the second resonance line and the fourth resonance line are disposed to overlap each other in plan view,
one of the first dielectric layer and the second dielectric layer includes a third ground part connected to the third resonance line via a third connector,
one of the first dielectric layer and the second dielectric layer includes a fourth ground part connected to the fourth resonance line via a fourth connector, and
the third ground part and the fourth ground part are separated from each other.

2. The electromagnetic resonance coupler according to claim 1,
wherein one of the first dielectric layer and the second dielectric layer includes a first ground part connected to the first resonance line via a first connector,
one of the first dielectric layer and the second dielectric layer includes a second ground part connected to the second resonance line via a second connector, and
the first ground part and the second ground part are separated from each other.

3. The electromagnetic resonance coupler according to claim 1,
wherein the first resonance line and the second resonance line connected together on the top surface of the first dielectric layer are connected to a fifth ground part included in one of the first dielectric layer and the second dielectric layer, via at least one of a first connector and a second connector included in one of the first dielectric layer and the second dielectric layer.

4. The electromagnetic resonance coupler according to one of claim 2 and claim 3,
wherein the first connector, the second connector, the third connector, and the fourth connector are connected respectively to one end of the first resonance line, one end of the second resonance line, one end of the third resonance line, and one end of the fourth resonance line.

5. The electromagnetic resonance coupler according to any one of claim 1 to claim 4,
wherein a contour of the first resonance line substantially matches a contour of the third resonance line in plan view, and
a contour of the second resonance line substantially matches a contour of the fourth resonance line in plan view.

6. The electromagnetic resonance coupler according to any one of claim 1 to claim 5,
wherein contours of the first resonance line and the second resonance line are surrounded by a first ground line on the top surface of the first dielectric layer, and
contours of the third resonance line and the fourth resonance line are surrounded by a second ground line on the back surface of the second dielectric layer.

7. The electromagnetic resonance coupler according to claim 6,
wherein the first ground line is connected to at least one of a first ground part and a second ground part via a fifth connector, and
the second ground line is connected to at least one of the third ground part and the fourth ground part via a sixth connector.

8. A gate drive circuit that is an insulated gate drive circuit and drives a semiconductor switching element, the gate drive circuit comprising:
a modulator circuit that generates: a first modulated signal by modulating a high-frequency signal in response to an input signal; and a second modulated signal by modulating the high-frequency signal in response to an input signal different from the input signal used for the first modulated signal;
a first electromagnetic resonance coupler that transmits the high-frequency signal and the first modulated signal in an electrically insulated manner;
a second electromagnetic resonance coupler that transmits the second modulated signal in the electrically insulated manner;
a first rectifier circuit that generates a first signal by rectifying the first modulated signal transmitted in the electrically insulated manner from the first electromagnetic resonance coupler;
a second rectifier circuit that generates a second signal by rectifying the second modulated signal transmitted in the electrically insulated manner from the second electromagnetic resonance coupler;
a third rectifier circuit that generates a charging voltage by rectifying the high-frequency signal transmitted in the electrically insulated manner from the first electromagnetic resonance coupler;
a capacitor charged in accordance with the charging voltage; and
an output circuit that selects, in accordance with at least one of the first signal and the second signal, whether to supply electricity charged in the capacitor to a gate terminal of the semiconductor switching element,
wherein the first electromagnetic resonance coupler is a gate drive circuit operating as the electromagnetic resonance coupler according to any one of claim 1 to claim 7.

9. The gate drive circuit according to claim 8,
wherein the output circuit is a half bridge circuit including: a first switching element on a high side; and a second switching element connected in series with the first switching element on a low side,
the first rectifier circuit is connected to a control terminal of the second switching element, and
the second rectifier circuit is connected to a control terminal of the first switching element.

10. A signal transmission device, comprising:
a signal transmitter that transmits a plurality of signals;
a signal transmission part that transmits the plurality of signals independently; and
a signal receiver that receives the plurality of signals transmitted independently,
wherein the signal transmission part is a signal transmission device including the electromagnetic resonance coupler according to any one of claim 1 to claim 7.
